# EUROPEAN PATENT APPLICATION

(11) **EP 4 231 366 A1**
(43) Date of publication of application: **23.08.2023**
(21) Application number: 22157779.4
(22) Date of filing: 21.02.2022
(51) Int. Cl.: H01L 45/00

(54) **AN INTEGRATED CIRCUIT COMPRISING A RESISTIVE SWITCHING SECTION**

(71) Applicant: ETH Zurich, 8092 Zurich (CH)
(72) Inventor: CHENG, Bojun, 8006 Zürich (CH); LEUTHOLD, Juerg, 8173 Neerach (CH); EMBORAS, Alexandros, 8005 Zürich (CH)
(74) Representative: Gygi, Andreas

(57) **Abstract**

An integrated circuit (IC) comprises a resistive switching section (1) with an active layer (14) arranged between a first electrode (11) and a second electrode (12), wherein the resistive switching section (1) is configured:
- to provide an electrical resistance between the first and second electrode (11, 12) which is switchable between different resistance values (LR, HR) depending on an electrical signal (U, I) applied to the first and the second electrode (11, 12), and
- to emit photons (15) during or associated with switching between the resistance values (LR, HR).

## Description

### FIELD OF THE INVENTION

The present invention relates to an integrated circuit comprising a resistive switching section.

### BACKGROUND ART

Compact, on-chip electrically-driven photon sources which offer a compact footprint, low power consumption, and compatibility with standard CMOS fabrication processes enable applications in various fields, such as optically interconnecting processors and memories, optically communicating a sensing event, quantum communications, neuromorphic computing, etc.

Quantum dot based light sources enable efficient operation with controlled spectra, but require complex fabrication processes. Electrically-driven light emitting tunnel junctions are compact and versatile, but vertically stacked architectures require large injection areas as well as fine control for fabricating a thin oxide barrier, and in-plane architectures require advanced nanofabrication or a non-scalable stochastic arrangement.

US6890777B2 discloses an electronic device comprising a population of quantum dots embedded in a host matrix and a primary light source which causes the dots to emit secondary light of a selected color, and a method of making such a device. The size distribution of the quantum dots is chosen to allow light of a particular color to be emitted therefrom. The light emitted from the device may be of either a pure (monochromatic) color, or a mixed (polychromatic) color, and may consist solely of light emitted from the dots themselves, or of a mixture of light emitted from the dots and light emitted from the primary source. The dots desirably are composed of an undoped semiconductor such as CdSe, and may optionally be overcoated to increase photoluminescence.

WO2020231926A1 discloses a Light Emitting Tunnel Junction (LETJ) which has a first layer, a second layer, and a gap layer disposed between said first layer and said second layer, forming a junction across which carriers tunnel upon being electrically biased. This so-biased tunnel junction generates light such as a photon, surface plasmon, or hybrids thereof either as a single light particle emitter denoting a quantum source, or emitting a plurality of said light particles either spontaneously or stimulated (lasing). This tunnel junction light source may include an optical resonator and/or may couple its emission to a waveguiding or fiber system.

KR20150111674 relates to a memristor-based device which includes an ITO (Indium Tin Oxide) coated plate and an electrode on a layer section in which a material performs a function of a memristor and a diode (LED) for forming a Memorizable Light Emitting Device. The diode is electrically connected to the resistance state of the memristor. Light is turned off when a voltage less than a predetermined voltage is applied.

### DISCLOSURE OF THE INVENTION

There may be a need for an integrated circuit which avoids at least certain disadvantages of the prior art. More particularly, there may be a need for an integrated circuit which enables emitting photons without an external light source. More particularly, there may be a need for an integrated circuit which enables emitting photons and features a compact footprint of transistors. More particularly, there may be a need for an integrated circuit which enables emitting photons and which enables embedding electrical and optical functionalities on the same nanoscale component, in particular on the basis of standard CMOS fabrication processes.

Such a need may be met with the subject-matter of the independent claims. Advantageous embodiments are defined in the dependent claims.

Ideas underlying embodiments of the present invention may be interpreted as being based, inter alia, on the following observations and recognitions.

An aspect of the invention relates to an integrated circuit comprising a resistive switching section with an active layer arranged between a first electrode and a second electrode, wherein the resistive switching section is configured: to provide an electrical resistance between the first and second electrode which is switchable between different resistance values depending on an electrical signal applied to the first and the second electrode, and to emit photons during or associated with switching between the resistance values. For example, the resistive switching section fabricated using a CMOS fabrication process. A small footprint is enabled. Emission of photons without an external light source is enabled. Embedding electrical and optical functionalities on the same nanoscale component is enabled.

In some embodiments, the electrical resistance is switchable between a low resistance value and a high resistance value. For example, the resistive switching device has the form of a memristor with a resistance which is switchable between a low resistance value and a high resistance value.

In some embodiments, the electrical signal is a voltage signal or a current signal, in particular an increasing or decreasing voltage signal, or an increasing or decreasing current signal. Driving the resistive switching device using widely available electronic circuits is enabled.

In some embodiments, the electrical resistance is switchable from a high resistance value to a low resistance value when the electrical signal crosses a first threshold, and from a low resistance value to a high resistance value when the electrical signal crosses a second threshold which is different from the first threshold. Emission of photons is enabled when crossing the first threshold, and/or when crossing the second threshold. Simple triggering of the emission of photons by widely available electronic circuits is enabled.

In some embodiments, for enhancing photon emission the resistive switching section exhibits a Purcell effect. Improving efficiency of photon emission is enabled.

In some embodiments, for enhancing photon emission an antenna, a reflection layer, and/or a lens is arranged. Improving efficiency of photon emission is enabled.

In some embodiments, the integrated circuit further comprises one or more waveguides, at least some of which coupled with the resistive switching section, for enabling photon transmission. Processing of emitted photons is enabled.

In some embodiments, the integrated circuit further comprises a plurality of resistive switching sections. Complex optical functionalities are enabled.

In some embodiments, the integrated circuit further comprises one or more electrical sections. Complex electrical functionalities are enabled.

In some embodiments, the integrated circuit is fabricated according to a CMOS process. Fabrication using well established fabrication processes is enabled.

In some embodiments, the active layer includes an oxide, in particular a silicon dioxide, tantalum oxide, tungsten oxide, hafnium oxide and/or titanium oxide, a nitride, in particular a titanium nitride, aluminum nitride, tantalum nitride, and/or gallium aluminum nitride, an aluminum, and/or a solid-state electrolyte, in particular a polymer, or one or more stacks thereof. For example, the active layer includes a stack of titanium nitride and aluminum nitride and aluminum nitride. For example, the active layer includes a stack of titanium nitride and aluminum nitride and aluminum. For example, the active layer includes a stack of tantalum nitride and gallium aluminum nitride and aluminum.

In some embodiments, the resistive switching section includes a silver-doped hafnium dioxide, copper, hafnium dioxide, silver, titanium dioxide, copper sulfide, amorphous silicon, silver telluride, titanium nitride, wolfram, tungsten, platinum, gold, titanium, cobalt, and/or indium tin oxide, or one or more combinations thereof. For example, a combination of copper / hafnium dioxide. For example, a combination of silver / titanium dioxide. For example, a combination of silver / amorphous silicon. For example, a combination of silver telluride / titanium nitride / titanium dioxide / titanium nitride. For example, a combination of wolfram / copper sulfide.

In some embodiments, the integrated circuit further includes a substrate, in particular for supporting the resistive switching section.

In some embodiments, the resistive switching section has an in-plane or horizontal configuration, or a vertical configuration.

In some embodiments, resistive switching section has the form of a conductive-bridging-random-access-memory-type memristor or another electrochemical metallization memory device or a valence change mechanism device.

The invention further relates to a method for fabricating an integrated circuit as described above. The method comprises: arranging at the integrated circuit a first electrode and a second electrode, and arranging an active layer between the first electrode and the second electrode. The electrodes and the active layer are arranged for providing a resistive switching section which is configured: to provide an electrical resistance between the first and second electrode which is switchable between different resistance values depending on an electrical signal applied to the first and the second electrode, and to emit photons during or associated with switching between the resistance values.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1a, 1b schematically show an integrated circuit IC according to the present invention.
Fig. 2a, 2b schematically show an integrated circuit IC according to the present invention further having arranged an antenna.
Fig. 3a, 3b, 3c schematically show an integrated circuit IC according to the present invention further having arranged a waveguide.
Fig. 4a, 4b schematically show an integrated circuit IC according to the present invention further having arranged a lens.
Fig. 5 schematically shows an integrated circuit according to the present invention comprising a resistive switching section.
Fig. 6 schematically shows a possible voltage-current sweep of the integrated circuit shown in Fig. 5.
Fig. 7 schematically shows a perspective view of a resistive switching section of an integrated according to the present invention.
Fig. 8 shows a SEM (Scanning Electron Microscope) image of a resistive switching section of an integrated circuit according to the present invention.
Fig. 9 schematically shows an integrated circuit according to the present invention which includes a plurality of resistive switching sections and one or more waveguides.
Fig. 10 schematically shows an integrated circuit according to the present invention which includes a plurality of resistive switching sections, one or more waveguides and one or more electrical sections.
Fig. 11a, 11b schematically show possible method steps for fabricating an integrated circuit according to the present invention.

The figures are only schematic and not to scale. Same reference signs refer to same or similar features.

### MODE(S) FOR CARRYING OUT THE INVENTION

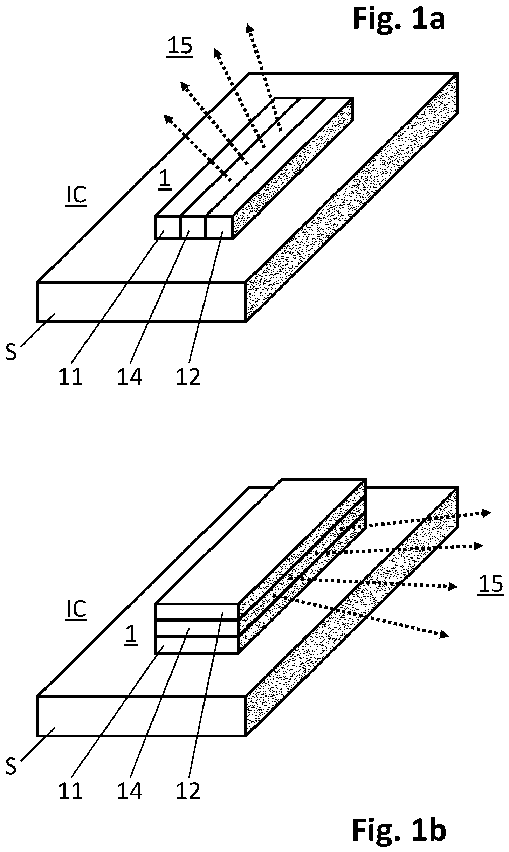

Fig. 1a, 1b schematically show an integrated circuit IC according to the present invention comprising a resistive switching section 1 with an active layer 14 arranged between a first electrode 11 and a second electrode 12. Materials, geometries, etc. of the resistive switching section 1 are chosen as described in the present disclosure such that the resistive switching section 1 is configured to provide an electrical resistance between the first and second electrode 11, 12 which is switchable between different resistance values LR, HR depending on an electrical signal U, I applied to the first and the second electrode 11, 12. Materials, geometries, etc. of the resistive switching section 1 are chosen as described in the present disclosure such that the resistive switching section 1 is configured to emit photons 15 during or associated with switching between the resistance values.

In particular, materials, geometries, etc. of the resistive switching section 1 are chosen such that the resistive switching section 1 forms a memristor.

The electrical signal U, I triggers an unipolar, abrupt, and reversible resistance switch, and emission of photons during or associated with the resistance switch. The resistance is decreased when a predefined electrical signal U, I pulse is applied, which can be positive or negative. The resistance is increased when another predefined electrical signal U, I pulse is applied, which can be positive or negative.

Fig. 1a schematically shows a resistive switching section 1 which has an in-plane or horizontal configuration, wherein photons 15 are emitted in particular in a vertical direction. Fig. 1b schematically shows a resistive switching section 1 which has a vertical configuration, wherein photons are emitted in particular in a horizontal direction.

As described in the present disclosure, the electrical resistance between the first and second electrode is in particular switchable between a low resistance value LR and a high resistance value HR.

As described in the present disclosure, the electrical signal U, I is a voltage signal U or a current signal I, in particular an increasing or decreasing voltage signal U or an increasing or decreasing current signal I, wherein in particular the electrical resistance between the first and second electrode is switchable from a high resistance value HR to a low resistance value when the electrical signal U, I crosses a first threshold, and from a low resistance value LR to a high resistance value HR when the electrical signal U, I crosses a second threshold which is different from the first threshold.

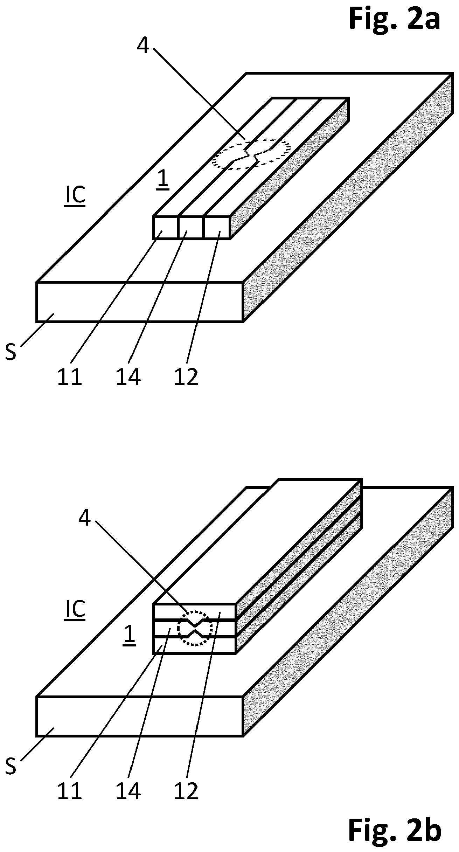

Fig. 2a, 2b schematically show an integrated circuit IC according to the present invention having arranged an antenna. The electrodes 11, 12 are formed to provide an antenna 4 for enhancing photon emission.

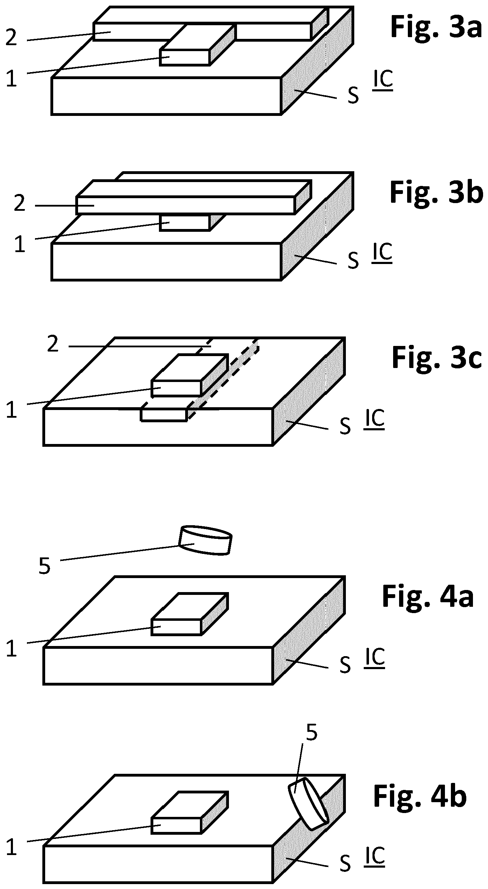

Fig. 3a, 3b, 3c schematically show an integrated circuit IC according to the present invention having arranged a waveguide 2. The waveguide 2 enables photon transmission. Fig. 3a schematically shows a waveguide 2 arranged on a side of a resistive switching section 1. Fig. 3b schematically shows a waveguide 2 arranged above a resistive section 1. Fig. 3c schematically shows a waveguide 2 arranged below a resistive switching section 1. The resistive switching section 1 and/or the waveguide 2 may be supported by a substrate S. The waveguide 2 may be embedded in the substrate S.

Fig. 4a, 4b schematically show an integrated circuit IC according to the present invention having arranged a lens 5. The lens 5 is arranged for enhancing photon emission. Fig. 4a schematically shows a lens 5 arranged above a resistive switching section 1. Fig. 4b schematically shows a lens 5 arranged on a side of a resistive switching section 1.

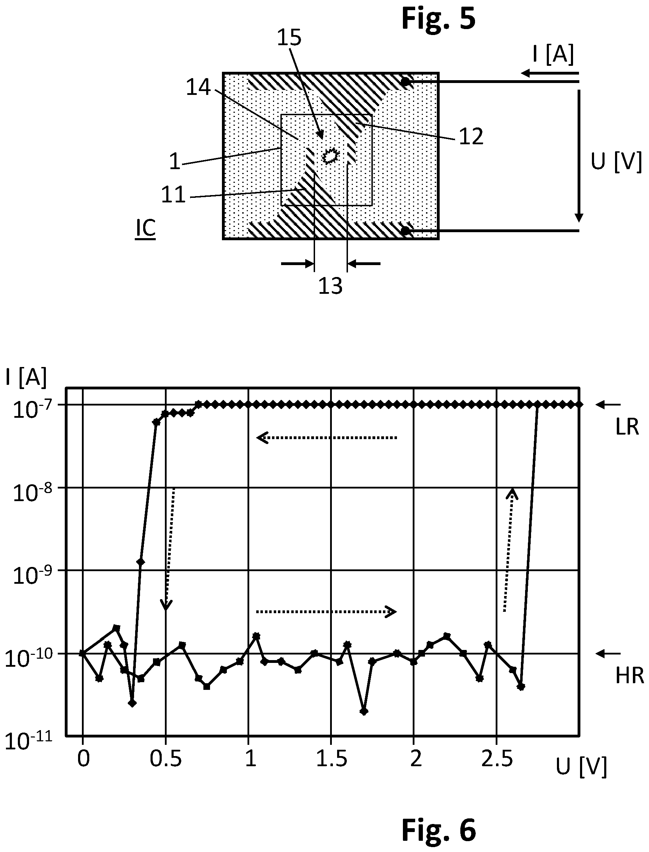

Fig. 5 schematically shows an embodiment of an integrated circuit IC according to the present invention comprising a resistive switching section 1. The resistive switching section 1 comprises an active layer 14 arranged between a first electrode 11 and a second electrode 12. Thus, the first and second electrode 11, 12 are separated by a gap 13. The active layer 14 fills the gap 13, and possibly is also arranged elsewhere, which may depend on the fabrication process for fabricating the integrated circuit IC. The electrodes 11, 12, in particular their materials, the gap 13, in particular its size, and the active layer 14, in particular its material, are configured as described in the present disclosure to provide a resistive switching section 1, in particular a memristor, which provides an electrical resistance between the first and second electrode 11, 12 which is switchable between different resistance values LR, HR depending on an electrical signal U, I applied to the first and the second electrode 11, 12, and which emits photons 15 during or associated with switching between the resistance values LR, HR.

In some embodiments, in a first fabrication step, the first and second electrode 11, 12 are deposited on a substrate (not shown in Fig. 5), wherein a gap 13 is left between the electrodes 11, 12, and in a second fabrication step an active layer 14 is deposited, for example sputtered, for arranging the active layer 14 in the gap 13, as illustrated, for example, in Fig. 1a.

In some embodiments, in a sequence of fabrication steps, the first electrode 11, the active layer 14, and the second electrode 12 are deposited, for example sputtered, for arranging the active layer 14 between the first electrode 11 and the second electrode 12, as illustrated, for example, in Fig. 1b.

The resistive switching section 1, which in particular has the form of a memristor, is provided by appropriately configuring materials, geometries, etc., as disclosed herein, such that the resistive switching section 1 has the property of providing an electrical resistance which is switchable for example between a high resistance value HR and a low resistance value LR, and which has the property of emitting photons during or associated with switching.

Fig. 6 schematically shows a switching cycle of the resistive switching section 1 of the integrated circuit IC shown in Fig. 5. A voltage signal U in the form of a voltage sweep is applied to the electrodes 11, 12 of the resistive switching section 1. In Fig. 6, the voltage sweep is indicated schematically by dashed arrows. The switching cycle is characteristic for a threshold switching device. In the following, voltages and currents of a possible embodiment are described. For example, the voltage signal U starts with a voltage of U=0V. As shown in Fig. 6, at voltage of U=0V, the resistance has a high resistance value HR, wherein a current of for example I=10⁻¹⁰A (0.1 nA) flows through the resistive switching section 1. The voltage signal U is then increased, wherein the resistance of the resistive switching section 1 a high resistance value HR. At a first threshold of for example 2.6V, the resistance switches from the high resistance value HR to a low resistance value LR. At low resistance value LR, a current of for example I=10⁻⁷A (100 nA) flows through the resistive switching section 1. After reaching a voltage of for example 3V, the voltage signal U is decreased, wherein the resistance has the low resistance value LR. At a second threshold of for example 0.3V, the resistance switches from the low resistance value LR to the high resistance value HR. The voltage signal U may then be decreased to a voltage of for example U=0V, and a new cycle of a voltage sweep may be started.

As shown in Fig. 6, the resistance is switchable between a high resistance value HR and a low resistance value LR depending on a voltage signal U applied between the first electrode 11 and the second electrode 12.

During or associated with switching, or as a result of switching, the resistive switching section 1 emits photons 15. In particular, the photons are generated in the active layer 14 arranged in the gap 13 between the electrodes 11, 12.

According to a specific embodiment, the resistive switching section 1 is formed from Pt/SiOx/Ag (for example the first electrode 11 includes Pt, the active layer 14 includes SiOx, and the second electrode 12 includes Ag) with the following results. Photon emission occurs both when switching from a high resistance value HR to a low resistance value LR, and also when switching from a low resistance value LR to a high resistance value HR. The transient photon emission is distinctively different from what is observed in a tunnel junction emitter, where the inelastic electron tunneling leads to a continuous emission for a constant resistive state. Despite atomic dimensions, the resistive switching section 1 features a robust operation. For example, a series of alternating 5V and 0.5V voltage pulses of 5ms (millisecond) duration applied to an exemplary resistive switching section 1 demonstrated emission of bursts of photons whenever an electrical stress is applied. Tests demonstrated photon emission during approx. 100 cycles. Endurance tests were performed for devices with a similar material stack with 50'000 consecutive cycles without a single failure. The spectrum of the emitted photons spans near-infrared with an emission peak at approx. 745nm.

In some embodiments, the resistive switching section 1 exhibits a Purcell effect for enhancing photon emission. For example, the Purcell effect may result from a nano antenna or a nano cavity. Many different kinds of systems exist in which the rate of spontaneous emission is modified by the environment, including cavities, two, and three-dimensional photonic bandgap materials.

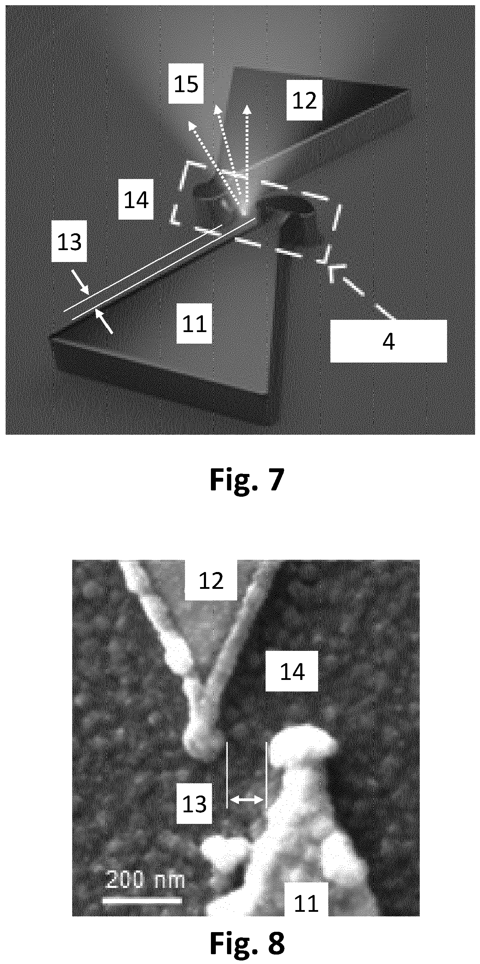

In some embodiments, the resistive switching section 1 includes an antenna 4 for enhancing photon emission. For example, as shown in Fig. 7, a plasmonic nanoantenna 4 is connected to the apex of two quasi-triangular metal contact electrodes 11, 12 to enhance the radiation and collection efficiencies. Fig. 8 is a SEM (Scanning Electron Microscope) image of a resistive switching section 1, wherein the apex of the electrodes 11, 12 form the nanoantenna. A sputtered matrix 14 covers the resistive switching section 1. The plasmonic nanoantenna optimizes quantum efficiency. The tip of the electrodes 11, 12 may include a geometry tuned to the emission peak of the emitted spectrum. Fig. 7, 8 show a specific embodiment of an antenna 4 shown in Fig. 2a, 2b.

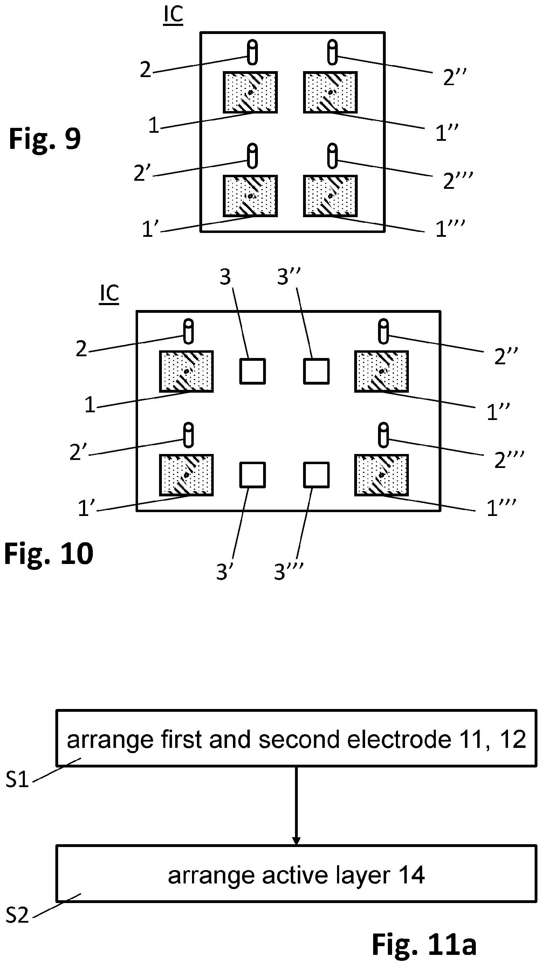

Fig. 9 schematically shows an integrated circuit IC which includes a plurality of resistive switching sections 1, 1', 1", .... Furthermore, the integrated circuit IC shown in Fig. 9 includes one or more waveguides 2, 2', 2",.... The waveguides 2, 2', 2", ... enable transmission of photons. Any number of resistive switching sections 1, 1', 1", ... and waveguides 2, 2', 2", ... may be arranged.

Fig. 10 schematically shows an integrated circuit which includes a plurality of resistive switching sections 1, 1', 1", .... Furthermore, the integrated circuit IC shown in Fig. 10 includes one or more waveguides 2, 2', 2", .... Furthermore, the integrated circuit IC shown in Fig. 10 includes one or more electrical sections 3, 3', 3", .... The electrical sections 3, 3', 3", ... enable electrical functions such as amplification and transmission of electrical signals, etc. Any number of resistive switching sections 1, 1', 1", ... and waveguides 2, 2', 2", ... and electrical sections 3, 3', 3", ... may be arranged.

In some embodiments, the integrated circuit IC is fabricated according to a CMOS process (Complementary metal-oxide-semiconductor). CMOS processes are widely available. Fabrication of an integrated circuit IC with electrical sections and resistive switching sections is enabled.

In some embodiments, the first electrode 11 includes or consists of Silver (Ag), the second electrode 12 includes or consists of Platin (Pt), and the active layer 14 includes or consists of a Silicon-Oxide (SiOx). The resistive switching section 1 exhibits photon emission during resistance switching. The photon emission by resistance switching is more generic and not limited to the Pt/SiOx/Ag material system, but also enabled by materials, geometries, etc. as described in the present disclosure.

In some embodiments, a substrate S is provided for supporting the resistive switching section 1. Accordingly, the electrodes 11, 12 and the active layer 14 may be arranged on a substrate S.

In some embodiments, the integrated circuit IC according to the present invention is designed for low-bit rate applications, for example in the field of sensing. For example, the integrated circuit is designed to communicate a state or a value of a sensor to a receiver, wherein communication comprises only a few bits of information. An integrated circuit comprising a resistive switching section 1 according to present invention is well suited for applications where the bit-rate is low. For example, a low-bit rate application relates to a bit-rate of below 700 bit/s, or of below 500 bit/s, or of below 1 Gbit/s.

Fig. 11a schematically shows possible method steps for fabricating an integrated circuit IC according to the present invention, for example having an in-plane or horizontal configuration of a resistive switching section 1. In step S1, a first and a second electrode 11, 12 are arranged at the integrated circuit IC, and in step S2, an active layer 14 is arranged between the first and second electrode 11, 12. In steps S1, S2, the first and second electrode 11, 12 and the active layer 14 are arranged for providing a resistive switching section 1 which is configured to provide an electrical resistance between the first and second electrode 11, 12 which is switchable between different resistance values LR, HR depending on an electrical signal U, I applied to the first and the second electrode 11, 12, and to emit photons 15 during or associated with switching between the resistance values LR, HR.

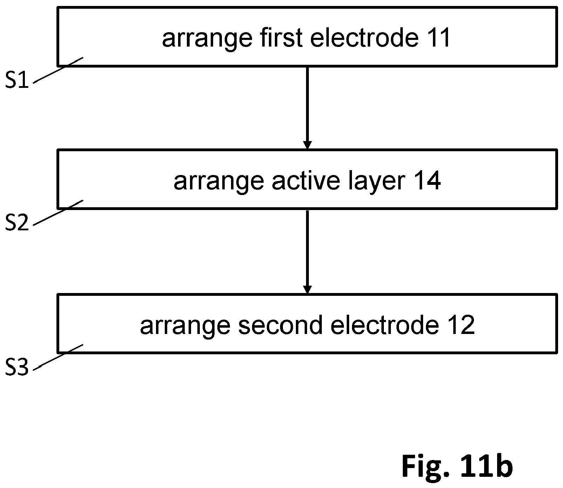

Fig. 11b schematically shows possible method steps for fabricating an integrated circuit IC according to the present invention, for example having a vertical configuration of a resistive switching section 1. In step S1, a first electrode 11 is arranged at the integrated circuit IC, and in step S2, an active layer 14 is arranged, and in step S3, a second electrode 12 is arranged such that the active layer 14 is arranged between the first and second electrode 11, 12. In steps S1, S2, S3, the first and second electrode 11, 12 and the active layer 14 are arranged for providing a resistive switching section 1 which is configured to provide an electrical resistance between the first and second electrode 11, 12 which is switchable between different resistance values LR, HR depending on an electrical signal U, I applied to the first and the second electrode 11, 12, and to emit photons 15 during or associated with switching between the resistance values LR, HR.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- IC: integrated circuit
- S: substrate
- 1: resistive switching section
- 11, 12: first and second electrode
- 13: gap separating the electrodes
- 14: active layer
- 15: photons
- LR: low resistance value
- HR: high resistance value
- U: voltage applied to the resistive switching section
- I: current flowing through the resistive switching section
- 2, 2', 2", ...: waveguides
- 3, 3', 3", ...: electrical sections
- 4: antenna
- 5: lens

## Claims

1. An integrated circuit (IC) comprising a resistive switching section (1) with an active layer (14) arranged between a first electrode (11) and a second electrode (12), wherein the resistive switching section (1) is configured:
- to provide an electrical resistance between the first and second electrode (11, 12) which is switchable between different resistance values (LR, HR) depending on an electrical signal (U, I) applied to the first and the second electrode (11, 12), and
- to emit photons (15) during or associated with switching between the resistance values (LR, HR).

2. The integrated circuit (IC) according to claim 1, wherein the electrical resistance is switchable between a low resistance value (LR) and a high resistance value (HR).

3. The integrated circuit (IC) according to one of claims 1 or 2, wherein the electrical signal (U, I) is a voltage signal (U) or a current signal (I), in particular an increasing or decreasing voltage signal (U), or an increasing or decreasing current signal (I).

4. The integrated circuit (IC) according to one of claims 1 to 3, wherein the electrical resistance is switchable from a high resistance value (HR) to a low resistance value (LR) when the electrical signal (U, I) crosses a first threshold, and from a low resistance value (LR) to a high resistance value (HR) when the electrical signal (U, I) crosses a second threshold which is different from the first threshold.

5. The integrated circuit (IC) according to one of claims 1 to 4, wherein for enhancing photon emission the resistive switching section (1) exhibits a Purcell effect.

6. The integrated circuit (IC) according to one of claims 1 to 5, wherein for enhancing photon emission one or more of an antenna, a reflection layer, and a lens is arranged.

7. The integrated circuit (IC) according to one of claims 1 to 6, further comprising one or more waveguides (2, 2', 2", ...), at least some of which coupled with the resistive switching section (1), for enabling photon transmission.

8. The integrated circuit (IC) according to one of claims 1 to 7, further comprising a plurality of resistive switching sections (1, 1', 1", ...).

9. The integrated circuit (IC) according to one of claims 1 to 8, further comprising one or more electrical sections (3, 3', 3", ...).

10. The integrated circuit (IC) according to one of claims 1 to 9, fabricated according to a CMOS process.

11. The integrated circuit (IC) according to one of claims 1 to 10, wherein the active layer (14) includes one or more of an oxide, in particular one or more of a silicon dioxide, tantalum oxide, tungsten oxide, hafnium oxide and titanium oxide, a nitride, in particular one or more of a titanium nitride, aluminum nitride, tantalum nitride, and gallium aluminum nitride, an aluminum, and a solid-state electrolyte, in particular a polymer, or one or more stacks thereof.

12. The integrated circuit (IC) according to one of claims 1 to 11, wherein the resistive switching section (1) includes one or more of a silver-doped hafnium dioxide, copper, hafnium dioxide, silver, titanium dioxide, copper sulfide, amorphous silicon, silver telluride, titanium nitride, wolfram, tungsten, platinum, gold, titanium, cobalt, and/or indium tin oxide, or one or more combinations thereof.

13. The integrated circuit (IC) according to one of claims 1 to 12, further including a substrate (S), in particular for supporting the resistive switching section.

14. The integrated circuit (IC) according to one of claims 1 to 13, wherein the resistive switching section (1) has an in-plane or horizontal configuration, or a vertical configuration.

15. A method for fabricating an integrated circuit (IC) according to one of claims 1 to 14, the method comprising:
arranging (S1) at the integrated circuit (IC) a first electrode (11) and a second electrode (12), and
arranging (S2) an active layer (14) between the first electrode (11) and the second electrode (12),
for providing a resistive switching section (1) which is configured:
- to provide an electrical resistance between the first and second electrode (11, 12) which is switchable between different resistance values (LR, HR) depending on an electrical signal (U, I) applied to the first and the second electrode (11, 12), and
- to emit photons (15) during or associated with switching between the resistance values (LR, HR).
